# EUROPEAN PATENT SPECIFICATION

(11) **EP 2 076 102 B1**
(45) Date of publication and mention of the grant of the patent: **18.04.2012**
(21) Application number: 08009521.9
(22) Date of filing: 23.05.2008
(51) Int. Cl.: H05K 3/38, H05K 1/02, H05K 1/18

(54) **Flexible film and display device comprising the same**
Flexible Folie und Anzeigevorrichtung damit
Film flexible et dispositif d'affichage comportant ce film

(30) Priority: 27.12.2007 KR 20070138831
(43) Date of publication of application: 01.07.2009
(73) Proprietor: LG Electronics Inc., Seoul 150-721 (KR)
(72) Inventor: Lee, Sang Gon, Chungju-si, Choongchungbuk-do 361-480 (KR); Kim, Dae Sung, Chungju-si, Choongchungbuk-do 361-480 (KR); Chang, Woo Hyuck, Chungju-si, Choongchungbuk-do 361-480 (KR)
(74) Representative: Katérle, Axel

(56) References cited:
- EP-A1- 1 599 076
- US-A- 5 042 919
- US-A1- 2006 079 029

## Description

### BACKGROUND OF THE INVENTION

### 1. Field of the Invention

The present invention relates to a flexible film, and more particularly, to a flexible film which includes a dielectric film whose surface is modified so as to provide a haze of 2-25% and a metal layer formed on the dielectric film and can thus contribute to the improvement of thermal resistance, dimension stability and tensile strength.

### 2. Description of the Related Art

With recent improvements in flat panel display technology, various types of flat panel display devices such as a liquid crystal display (LCD), a plasma display panel (PDP), and an organic light-emitting diode (OLED) have been developed. Flat panel display devices include a driving unit and a panel and display images by transmitting image signals from the driving unit to a plurality of electrodes included in the panel.

Printed circuit boards (PCBs) may be used as the driving units of flat panel display devices. That is, PCBs may apply image signals to a plurality of electrodes included in a panel and thus enable the panel to display images. The driving units of flat panel display devices may transmit image signals to a plurality of electrodes of a panel using a chip-on-glass (COG) method.

Document EP-A-1 599 076 discloses a flexible film comprising a dielectric film and a metal layer disposed on the dielectric film, wherein the haze of the dielectric film is 20%.

### SUMMARY OF THE INVENTION

The present invention provides a flexible film which includes a dielectric film whose surface has been modified so as to provide a haze of 2-25%, a metal layer formed on the modified surface of the dielectric film, and circuit patterns formed on the metal layer and can thus contribute to the improvement of thermal resistance, dimension stability and tensile strength.

According to an aspect of the present invention, there is provided a flexible film as defined in claim 1.

According to another aspect of the present invention, there is provided a display device including a panel; a driving unit; and a flexible film disposed between the panel and the driving unit as defined in claim 8.

### BRIEF DESCRIPTION OF THE DRAWINGS

The above and other features and advantages of the present invention will become more apparent by describing in detail preferred embodiments thereof with reference to the attached drawings in which:
FIGS. 1A through 1F illustrate cross-sectional views of flexible films according to embodiments of the present invention;
FIGS. 2A and 2B illustrate diagrams of a tape carrier package (TCP) comprising a flexible film according to an embodiment of the present invention;
FIGS. 3A and 3B illustrate diagrams of a chip-on-film (COF) comprising a flexible film according to an embodiment of the present invention;
FIG. 4 illustrates diagram of a display device according to an embodiment of the present invention;
FIG. 5 illustrates cross-sectional view of the display device 400 in FIG. 4; and
FIG. 6 illustrates diagram of a display device according to an embodiment of the present invention.

### DETAILED DESCRIPTION OF THE INVENTION

The present invention will hereinafter be described in detail with reference to the accompanying drawings in which exemplary embodiments of the invention are shown.

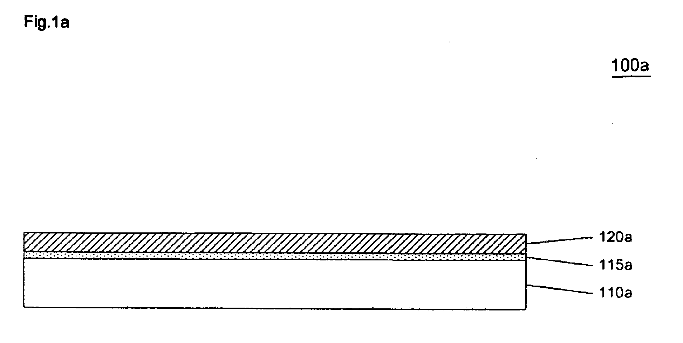

FIGS. 1A through IF illustrate cross-sectional views of flexible films 100a through 100f, respectively, according to embodiments of the present invention. Referring to FIGS. 1A through 1F, the flexible films 100a through 100f transmit an image signal provided by a driving unit of a tape automated bonding (TAB)-type display device to an electrode on a panel of the TAB-type display device.

More specifically, each of the flexible films 100a through 100f may be formed by forming a metal layer on a dielectric film and printing circuit patterns on the metal layer. Thus, the flexible films 100a through 100f may transmit an image signal provided by a driving unit of a display device to a panel of the display device. Circuit patterns of a flexible film used in a TAB-type display device may be connected to a circuit of a driving unit of the TAB-type display device or to an electrode on a panel of the TAB-type display device and may thus transmit a signal applied by the driving unit to the panel.

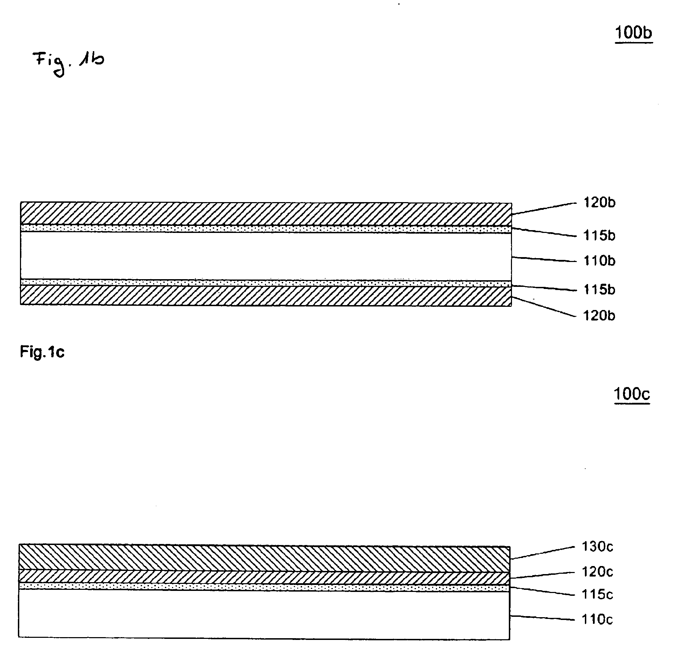

Referring to FIG. 1A, the flexible film 100a includes a dielectric film 110a and a metal layer 120a, which is formed on the dielectric film 110a. Referring to FIG. 1B, the flexible film 100b includes a dielectric film 110b and two metal layers 120b, which are formed on the top surface and the bottom surface, respectively, of the dielectric film 110b.

The dielectric film 110a or 110b is a base film of the flexible film 100a or 100b. The dielectric film 110a or 110b may be formed of a dielectric polymer material such as polyimide, polyester, or a liquid crystal polymer. The dielectric film 110a or 110b may have a thickness of 15-40 µm, and particularly, a thickness of 35-38 µm. The thickness of the dielectric film 110a or 110b may be determined so as to provide the dielectric film 110a or 110b with appropriate peel strength with respect to the metal layer 120a or the metal layers 120b. In order to improve the peel strength of the dielectric film 110a or 110b with respect to the metal layer 120a or the metal layers 120b, a surface 115a of the dielectric film 110a or surfaces 115b of the dielectric film 110b may be modified.

The surface 115a or the surfaces 115b may be modified using plasma, ion beams or alkali etching. More specifically, the surface 115a or the surfaces 115b may be modified by placing the dielectric film 110a or 110b in a chamber having a predetermined pressure and applying an electric power of 20-1000 W to the dielectric film 110a or 110b for 10-900 seconds.

Alternatively, the surface 115a or the surfaces 115b may be modified by irradiating ion beams having an energy of several hundreds of KeV to several MeV to the dielectric film 110a or 110b. When ion beams are applied to the dielectric film 110a or 110b, the ion beams collide with the surface 115a or the surfaces 115b. Thus, the temperature of the dielectric film 110a or 110b increases, and defects may be generated on the surface 115a or the surfaces 115b, thereby modifying the surface 115a or the surfaces 115b. Still alternatively, the surface 115a or the surfaces 115b may be modified by etching the dielectric film 110a or 110b using a solution containing hydroxide ions (-OH), for example, a potassium hydroxide (KOH) solution or a sodium hydroxide (NaOH) solution.

Table 1 shows test results obtained from dielectric films having different degrees of haze.

**Table 1**

| Haze | Peel Strength | Efficiency of Testing Circuit Patterns |
|---|---|---|
| 1% | × | ○ |
| 2% | ○ | ○ |
| 5% | ○ | ○ |
| 10% | ○ | ○ |
| 15% | ○ | ○ |
| 20% | ○ | ○ |
| 25% | ○ | ○ |
| 27% | ○ | × |
| 30% | ○ | × |

Referring to Table 1, the surface 115a or the surfaces 115b may be modified so that the dielectric film 110a or 110b can have a haze of 2-25%. If the haze of the dielectric film 110a or 110b is lower than 2%, the luminous transmittance of the dielectric film 110a or 110b may increase, and thus, the efficiency of testing circuit patterns on the flexible film 110a or 110b may also increase. On the other hand, if the haze of the dielectric film 110a or 110b is higher than 25%, the peel strength of the dielectric film 110a or 110b may increase, but the luminous transmittance of the dielectric film 110a or 110b may decrease, thereby lowering the efficiency of testing the circuit patterns of the flexible film 110a or 110b.

The haze of the dielectric film 110a or 110b may be measured according to America Society for Testing Material (ASTM) D1003 Standard. More specifically, a sample having a size of 50 mm or 100 mm is extracted from the dielectric film 110a or 110b, and the haze of the sample is measured according to ASTM D1003 Standard. In order to facilitate the modification of the surface 115a or the surfaces 115b and provide the dielectric film 110a or 110b with sufficient peel strength with respect to the metal layer 120a or the metal layers 120b, the dielectric film 110a or 110b may be formed of a polymer material such as polyimide or a liquid crystal polymer. The liquid crystal polymer may be a combination of p-hydroxybenzoic acid (HBA) and 6-hydroxy-2-naphthoic acid (HNA). HBA is an isomer of hydroxybenzoic acid having one benzene ring and is a colorless solid crystal. HNA has two benzene rings.

HBA may be represented by chemical formula (1):

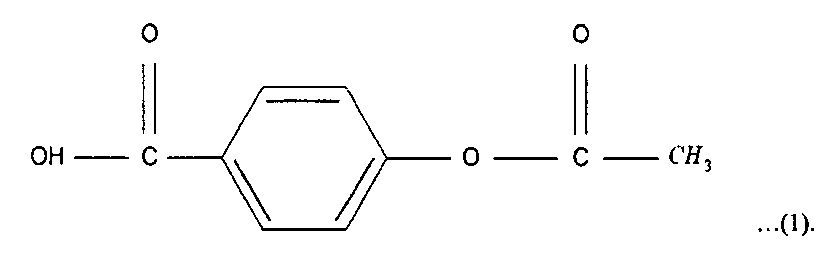

HNA may be represented by chemical formula (2):

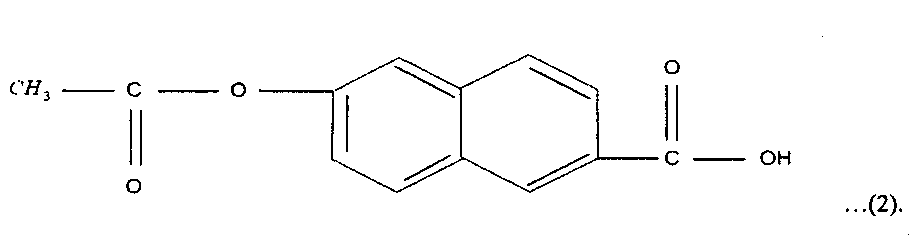

A chemical reaction of HBA and HNA to form a liquid crystal polymer may be represented by chemical formula (3):

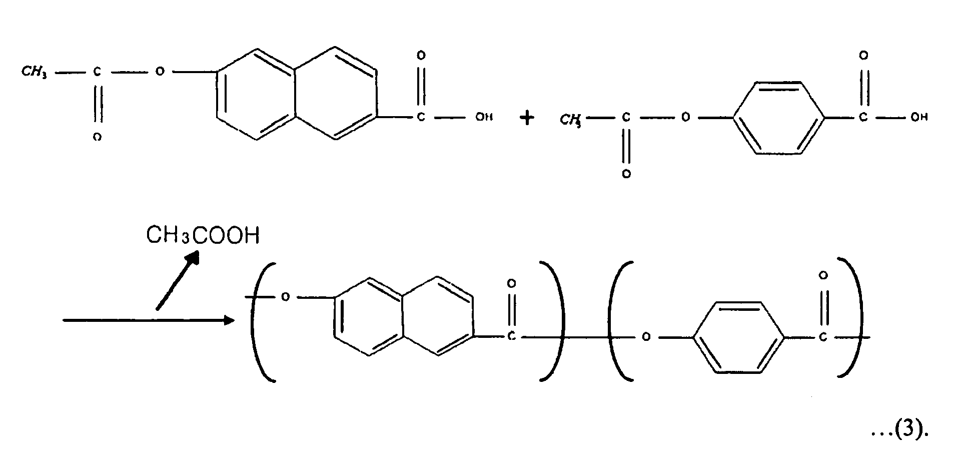

During the formation of a liquid crystal polymer, a carboxy radical (-OH) of HNA and an acetic group (CH₃CHO) of HBA are bonded, thereby forming acetic acid (CH₃COOH). This deacetylation reaction may be caused by heating a mixture of HNA and HBA at a temperature of about 200 °C.

The results of testing a liquid crystal polymer and polyimide for peel strength according to JIS C6471 Standard show that a liquid crystal polymer has a peel strength of 1.1 kN/m, and that polyimide has a peel strength of 0.3-0.9 kN/m. Therefore, it is possible to form a flexible film 100a or 100b having excellent peel strength by forming the dielectric film 110a or 110b using a polymer film including a liquid crystal polymer or polyimide, modifying the surface 115a or the surfaces 115b and forming the metal layer 120a or the metal layers 120b.

The metal layer 120a or the metal layers 120b are thin conductive metal layers. In the embodiments of FIGS. 1A and 1B, the metal layer 120a or the metal layers 120b have a single-layer structure. The metal layer 120a or the metal layers 120b may be formed through laminating or casting.

The metal layer 120a or the metal layers 120b may be formed through casting or laminating. More specifically, the metal layer 120a or the metal layers 120b may be formed through casting by applying a liquid-phase dielectric film on a metal film and drying and hardening the metal film in an oven at high temperature. Alternatively, the flexible film 100a or 100b may be formed through laminating by applying an adhesive on the dielectric film 110a or 110b, baking the dielectric film 110a or 110b so as to fix the adhesive on the dielectric film 110a or 110b, placing the metal layer 120a or the metal layers 120b on the dielectric film 110a or 110b, and performing press processing on the metal layer 120a or the metal layers 120b. The metal layer 120a or the metal layers 120b may include nickel, chromium, gold or copper.

The thickness of the metal layer 120a or the metal layers 120b may be determined according to the thickness of the dielectric film 110a or 110b. Table 1 shows test results obtained from flexible films including a dielectric film having a thickness of 38 µm.

**Table 2**

| Thickness of Metal Layer: Thickness of Dielectric Film | Flexibility | Peel Strength |
|---|---|---|
| 1:1.4 | × | ⊚ |
| 1:1.5 | ○ | ○ |
| 1:2 | ○ | ○ |
| 1:4 | ○ | ○ |
| 1:6 | ○ | ○ |
| 1:8 | ○ | ○ |
| 1:10 | ○ | ○ |
| 1:11 | ○ | × |
| 1:12 | ⊚ | × |
| 1:13 | ⊚ | × |

Referring to Table 2, If the thicknesses of the metal layer 120a is less than one tenth of the thickness of the dielectric film 110a, the peel strength of the metal layer 120a may decrease, and thus, the metal layer 120a may be easily detached from the dielectric film 110a or the stability of the dimension of the metal layer 120a may deteriorate. On the other hand, if the thicknesses of the metal layer 120a is greater than two thirds of the thickness of the dielectric film 110a, the flexibility of the flexible film 100a may deteriorate, and the time taken to perform plating may increase, thereby increasing the probability of the metal layer 120a being damaged by a plating solution.

For example, the metal layer 120a may be formed to a thickness of 4-13 µm, and the dielectric film 110a may be formed to a thickness of 15-40 µm. Thus, the ratio of the thickness of the metal layer 120a to the thickness of the dielectric film 110a may be 1:1.5 to 1:10. And this directly applies to a double-sided flexible film.

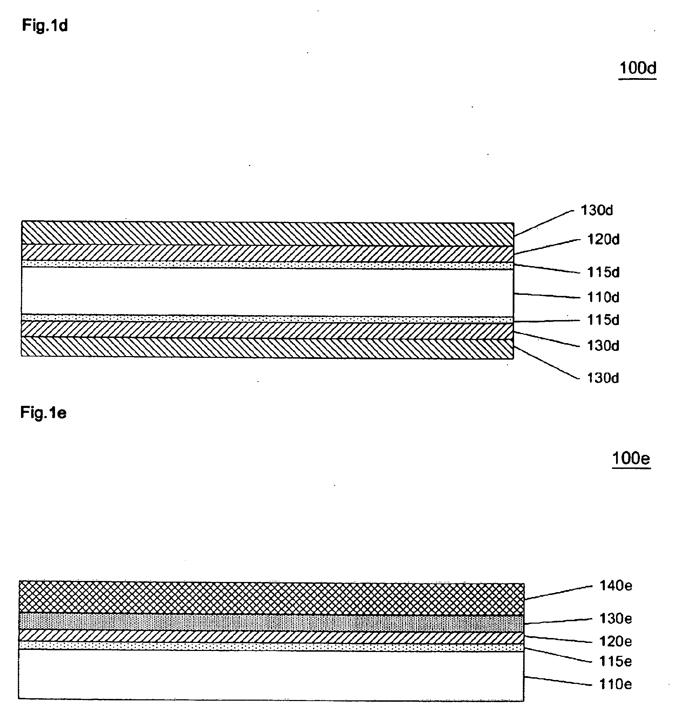

Referring to FIG. 1C, the flexible film 100c includes a dielectric film 110c and two metal layers, i.e., first and second metal layers 120c and 130c. The first metal layer 120c is disposed on the dielectric film 110c, and the second metal layer 130c is disposed on the first metal layer 120c. Referring to FIG. 1D, the flexible film 100d includes a dielectric film 110c and four metal layers, i.e., two first metal layers 120d and two second metal layers 130d. The two first metal layers 120d are disposed on the top surface and the bottom surface, respectively, of the dielectric film 110d, and the two second metal layers 130d are disposed on the respective first metal layers 120d.

The first metal layer 120c or the first metal layers 120d may be formed through sputtering or electroless plating, and may include nickel, chromium, gold or copper. More specifically, the first metal layer 120c or the first metal layers 120d may be formed through sputtering using an alloy of nickel and chromium. Particularly, the first metal layer 120c or the first metal layers 120d may contain 93-97% of nickel.

The first metal layer 120c or the first metal layers 120d may be formed through electroless plating by immersing the dielectric film 110c or 110d in an electroless plating solution containing metal ions and adding a reducing agent to the electroless plating solution so as to extract the metal ions as a metal. For example, the first metal layer 120c or the first metal layers 120d may be formed by immersing the dielectric film 110c or 110d in a copper sulphate solution, and adding formaldehyde (HCHO) to the copper sulphate solution as a reducing agent so as to extract copper ions from the copper sulphate solution as copper. Alternatively, the first metal layer 120c or the first metal layers 120d may be formed by immersing the dielectric film 110c or 110d in a nickel sulphate solution, and adding sodium hypophosphite (NaH₂PO₂) to the nickel sulphate solution as a reducing agent so as to extract nickel ions from the nickel sulphate solution as nickel.

The second metal layer 130c or the second metal layers 130d may include gold or copper. More specifically, the second metal layer 130c or the second metal layers 130d may be formed through electroplating, which involves applying a current and thus extracting metal ions as a metal. In this case, the thickness of the second metal layer 130c or the second metal layers 130d may be altered by adjusting the amount of current applied and the duration of the application of a current.

The sum of the thicknesses of the first metal layer 120c and the second metal layer 130c may account for one tenth to two thirds of the thickness of the dielectric film 110c. For example, if the thickness of the dielectric film 110c is 35-38 µm, the sum of the thicknesses of the first metal layer 120c and the second metal layer 130c may be 4-13 µm. More specifically, the first metal layer 120c may have a thickness of about 100 nm, and the second metal layer 130c may have a thickness of about 9 µm. This directly applies to a double-sided flexible film.

In order to improve the peel strength of the first metal layer 120c and the second metal layer 130c with respect to the dielectric film 110c or the peel strength of the first metal layers 120d and the second metal layers 130d with respect to the dielectric film 110d, a surface of the dielectric film 110c or surfaces of the dielectric film 110d may be modified using plasma, ion beams or alkali etching so as to provide a haze of 2-25%.

If the haze of the dielectric film 110c or 110d is lower than 2%, the luminous transmittance of the dielectric film 110c or 110d may increase, and thus, the efficiency of testing circuit patterns on the flexible film 110c or 110d may also increase. On the other hand, if the haze of the dielectric film 110c or 110d is higher than 25%, the peel strength of the dielectric film 110c or 110d may increase, but the luminous transmittance of the dielectric film 110c or 110d may decrease, thereby lowering the efficiency of testing the circuit patterns of the flexible film 110a or 110b.

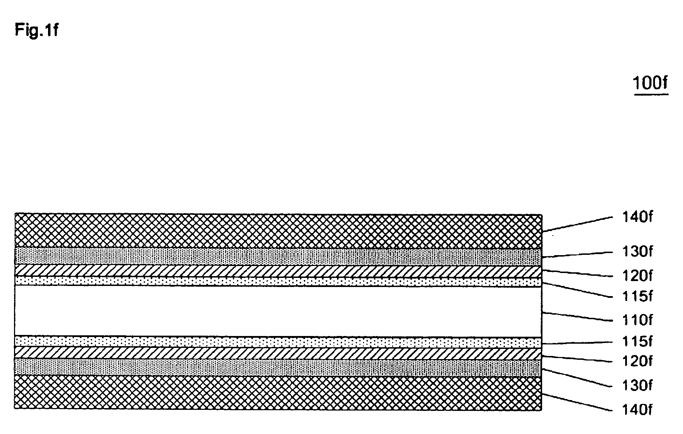

Referring to FIG. 1E, the flexible film 100e includes a dielectric film 110e and three metal layers, i.e., first, second and third metal layers 120e, 130e and 140e. The first metal layer 120e is disposed on the first metal layer 120e, the second metal layer 130e is disposed on the first metal layer 120e, and the third metal layer 140e is formed on the second metal layer 130e. Referring to FIG. 1F, the flexible film 100f includes a dielectric film 110f and six metal layers: two first metal layers 120f, two second metal layers 130f, and two third metal layers 140f. The two first metal layers 120f are disposed on the top surface and the bottom surface, respectively, of the dielectric film 110f, the two second metal layers 130f are disposed on the respective first metal layers 120f, and the two third metal layers 140f are disposed on the respective second metal layers 130f.

The first metal layer 120e or the first metal layers 120f may be formed through sputtering or electroless plating, and may include nickel, chromium, gold or copper. More specifically, the first metal layer 120e or the first metal layers 120f may be formed through sputtering using an alloy of nickel and chromium. Particularly, the first metal layer 120e or the first metal layers 120f may include 93-97% of nickel.

The first metal layer 120e or the first metal layers 120f may be formed through electroless plating by immersing the dielectric film 110e or 110f in an electroless plating solution containing metal ions and adding a reducing agent to the electroless plating solution so as to extract the metal ions as a metal. For example, the first metal layer 120e or the first metal layers 120f may be formed by immersing the dielectric film 110e or 110f in a copper sulphate solution, and adding formaldehyde (HCHO) to the copper sulphate solution as a reducing agent so as to extract copper ions from the copper sulphate solution as copper. Alternatively, the first metal layer 120e or the first metal layers 120f may be formed by immersing the dielectric film 110e or 110f in a nickel sulphate solution, and adding sodium hypophosphite (NaH₂PO₂) to the nickel sulphate solution as a reducing agent so as to extract nickel ions from the nickel sulphate solution as nickel.

The second metal layer 130e or the second metal layers 130f may be formed through sputtering. If the first metal layer 120e or the first metal layers 120f are formed of an alloy of nickel and chromium, the second metal layer 130e or the second metal layers 130f may be formed of a metal having a low resistance such as copper, thereby improving the efficiency of electroplating for forming the third metal layer 140e or the third metal layers 140f.

The third metal layer 140e or the third metal layers 140f may be formed through electroplating, and may include gold or copper. More specifically, the third metal layer 140e or the third metal layers 140f may be formed through electroplating, which involves applying a current to an electroplating solution containing metal ions and thus extracting the metal ions as a metal.

The ratio of the sum of the thicknesses of the first metal layer 120e, the second metal layer 130e, and the third metal layer 140e to the thickness of the dielectric film 110e may be 1:3 to 1:10. The ratio of the sum of the thicknesses of the first metal layer 120e, the second metal layer 130e, and the third metal layer 140e to the thickness of the dielectric film 110e may be determined according to the properties and the peel strength of the flexible film 100e. Once the third metal layer 140e is formed, circuit patterns may be formed by etching the first metal layer 120e, the second metal layer 130e, and the third metal layer 140e, and an adhesive layer may be formed on the circuit patterns.

For example, the first metal layer 120e may be formed to a thickness of 7-40 nm, and the second metal layer 130e may be formed to a thickness of 80-300 nm. The sum of the thicknesses of the first metal layer 120e, the second metal layer 130e, and the third metal layer 140e may be 4-13 µm so as for the third metal layer 140e to have sufficient peel strength and to provide sufficient flexibility to the flexible film 100e. Also, this directly applies to a double-sided flexible film.

In order to improve the peel strength of the first metal layer 120e, the second metal layer 130e, and the third metal layer 140e with respect to the dielectric film 100e or the peel strength of the first metal layers 120f, the second metal layers 130f, and the third metal layer 140f with respect to the dielectric film 100f, a surface 115e of the dielectric film 110e or surfaces 115f of the dielectric film 110f may be modified using plasma, ion beams or alkali etching so as to provide a haze of 2-25%.

If the haze of the dielectric film 110e or 110f is lower than 2%, the luminous transmittance of the dielectric film 110e or 110f may increase, and thus, the efficiency of testing circuit patterns on the flexible film 110e or 110f may also increase. However, the number of defects on the surface 115e or the surfaces 115f may decrease, and the peel strength of the dielectric film 110e or 110f may decrease. On the other hand, if the haze of the dielectric film 110e or 110f is higher than 25%, the peel strength of the dielectric film 110e or 110f may increase, but the luminous transmittance of the dielectric film 110e or 110f may decrease, thereby lowering the efficiency of testing the circuit patterns of the flexible film 110e or 110f.

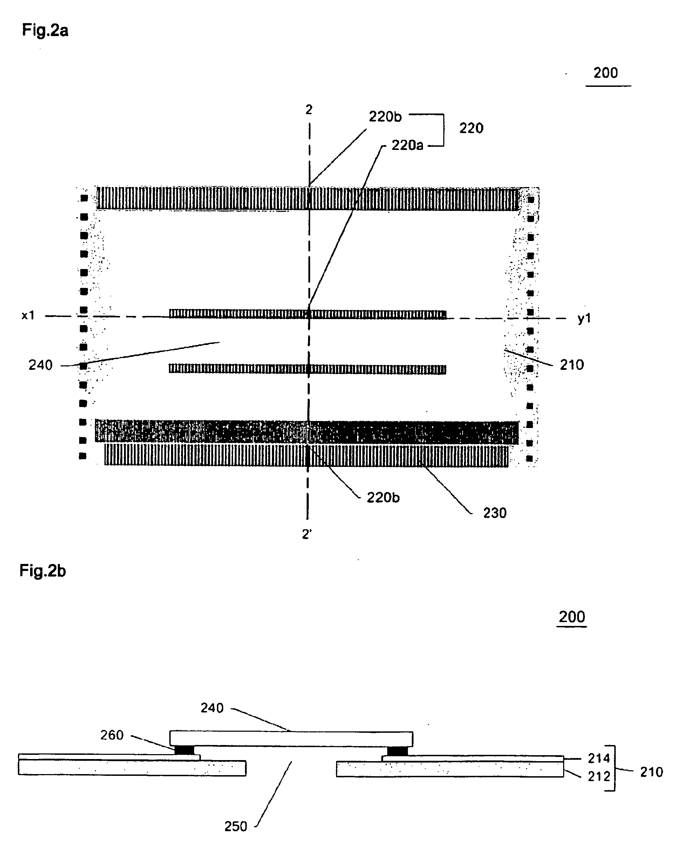

FIGS. 2A and 2B illustrate diagrams of a tape carrier package (TCP) 200 including a flexible film 210 according to an embodiment of the present invention. Referring to FIG. 2A, the TCP 200 includes the flexible film 210, circuit patterns 220, which are formed on the flexible film 210, and an integrated circuit (IC) chip 230, which is disposed on the flexible film 210 and is connected to the circuit patterns 220.

The flexible film 210 includes a dielectric film and a metal layer, which is formed on the dielectric film. The dielectric film is a base film of the flexible film 210 and may include a dielectric polymer material such as polyimide, polyester, or a liquid crystal polymer. The dielectric film must have excellent peel strength with respect to the metal layer in order to provide sufficient flexibility when the flexible film 210 is connected to a driving unit or a panel of a display device.

In order to improve the peel strength of the dielectric film with respect to the metal layer, the surface of the dielectric film may be modified before the formation of the metal layer on the dielectric film, thereby generating defects on the surface of the dielectric film. The surface of the dielectric film may be modified to the extent that the dielectric film has a haze of 2-25%. The haze of the dielectric film may be measured according to ASTM D1003 Standard.

If the haze of the dielectric film is lower than 2%, the peel strength of the dielectric film with respect to the metal layer may deteriorate. On the other hand, if the haze of the dielectric film is higher than 25%, the luminous transmittance of the dielectric film may decrease, and thus, the efficiency of testing the circuit patterns 220 may decrease. Therefore, the surface of the dielectric film may be modified so that the dielectric film can have a haze of 2-25%.

The results of testing polyimide and a liquid crystal polymer for peel strength according to JIS C6471 Standard show that polyimide has a peel strength of 0.3-0.9 kN/m with respect to the metal layer and that a liquid crystal polymer has a peel strength of 1.1 kN/m with respect to the metal layer. Therefore, the dielectric film may be formed of a liquid crystal polymer.

The metal layer may include a first metal layer, which is formed on the dielectric film, and a second metal layer, which is formed on the first metal layer. The first metal layer may be formed through electroless plating or sputtering, and the second metal layer may be formed through electroplating.

The first metal layer may include nickel, chromium, gold or copper. More specifically, the first metal layer may be formed of a highly-conductive metal such as gold or copper in order to improve the efficiency of electroplating for forming the second metal layer. For example, the first metal layer may be formed of an alloy of nickel and chromium through sputtering. In order to improve the efficiency of electroplating for forming the second metal layer, a copper layer may additionally be formed on the first metal layer, thereby providing a metal layer having a triple-layer structure.

Alternatively, the first metal layer may be formed through electroless plating by immersing the dielectric film in a copper sulphate-based electroless plating solution and extracting copper ions from the copper sulphate-based electroless plating solution as copper with the use of a reducing agent. A formaldehyde (HCHO)-series material may be used as the reducing agent. Still alternatively, the first metal layer may be formed of nickel by immersing the dielectric film in a nickel sulphate-based electroless plating solution and extracting nickel ions as nickel using sodium hypophosphite as a reducing agent.

The second metal layer may be formed by applying a current to a copper sulphate-based electroplating solution so as to extract copper ions as copper. The thickness of the second metal layer may be determined according to the amount of current applied. Once the second metal layer is formed, the circuit patterns 220 are formed by etching the first and second metal layers.

The circuit patterns 220 include inner leads 220a, which are connected to the IC chip 230, and outer leads 220b, which are connected to a driving unit or a panel of a display device. The pitch of the circuit patterns 220 may vary according to the resolution of a display device comprising the TCP 200. The inner leads 220a may have a pitch of about 40 µm, and the outer leads 220b may have a pitch of about 60 µm.

FIG. 2B illustrates a cross-sectional view taken along line 2-2' of FIG. 2A. Referring to FIG. 2B, the TCP 200 includes the flexible film 210, the IC chip 230, and gold bumps 240, which connect the flexible film 210 and the IC chip 230.

The flexible film 210 may include a dielectric film 212 and a metal layer 214, which is formed on the dielectric film 212. The dielectric film 212 is a base film of the flexible film 210 and may include a dielectric polymer material such as polyimide, polyester, or a liquid crystal polymer. The surface of the dielectric film 212 may be modified so as for the dielectric film 212 to have sufficient peel strength with respect to the metal layer 214 and to improve the efficiency of testing the circuit patterns 220. More specifically, the dielectric film 212 may be formed of polyimide or a liquid crystal polymer, and the surface of the dielectric film may be modified to so as to provide a haze of 2-25%.

The metal layer 214 is a thin layer formed of a conductive metal such as nickel, chromium, gold or copper. The metal layer 214 may have a double-layer structure including first and second metal layers. The first metal layer may be formed of nickel, gold, chromium or copper through electroless plating, and the second metal layer may be formed of gold or copper through electroplating. In order to improve the efficiency of electroplating for forming the second metal layer, the first metal layer may be formed of nickel or copper.

The IC chip 230 is disposed on the flexible film 210 and is connected to the circuit patterns 220, which are formed by etching the metal layer 214. The flexible film 210 includes a device hole 250, which is formed in an area in which the IC chip 230 is disposed. After the formation of the device hole 250, flying leads are formed on the circuit patterns 220, to which the IC chip 230 is connected, and the gold bumps 240 on the IC chip 230 are connected to the flying leads, thereby completing the formation of the TCP 200. The flying leads may be plated with tin. The flying leads may be plated with tin. A gold-tin bond may be generated between the tin-plated flying leads and the gold bumps 240 by applying heat or ultrasonic waves.

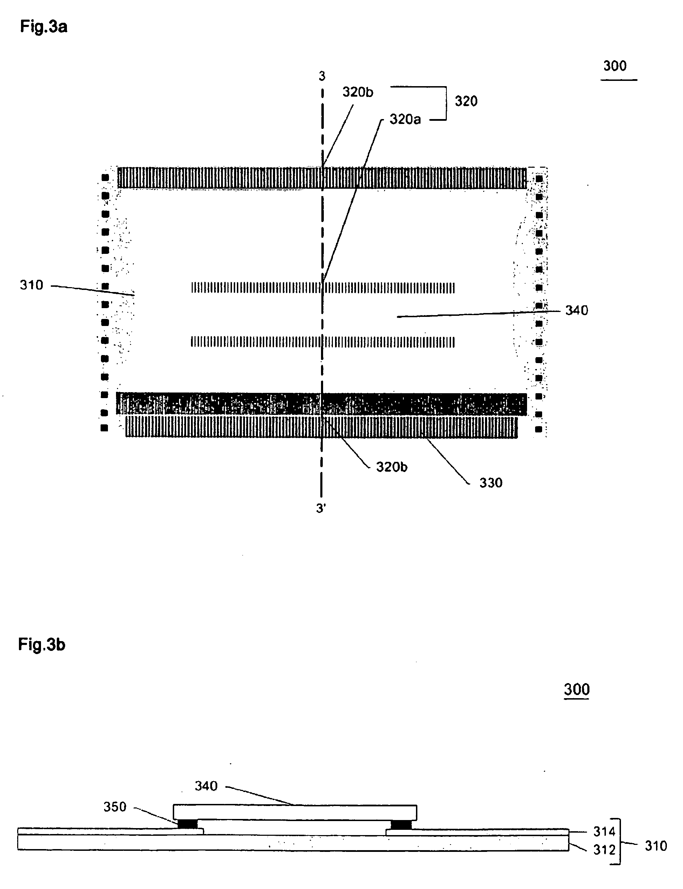

FIGS. 3A and 3B illustrate diagrams of a chip-on-film (COF) 300 including a flexible film 310 according to an embodiment of the present invention. Referring to FIG. 3A, the COF 300 includes the flexible film 310, circuit patterns 320, which are formed on the flexible film 310, and an IC chip 330, which is attached on the flexible film 310 and is connected to the circuit patterns 320.

The flexible film 310 may include a dielectric film and a metal layer, which is formed on the dielectric film. The dielectric film is a base film of the flexible film 310 and may include a dielectric material such as polyimide, polyester or a liquid crystal polymer. The dielectric film must have excellent peel strength with respect to the metal layer in order to provide sufficient flexibility when the flexible film 310 is connected to a driving unit or a panel of a display device.

In order to improve the peel strength of the dielectric film with respect to the metal layer, the surface of the dielectric film may be modified before the formation of the metal layer on the dielectric film, thereby generating defects on the surface of the dielectric film. The surface of the dielectric film may be modified to the extent that the dielectric film has a haze of 2-25%. The haze of the dielectric film may be measured according to ASTM D 1003 Standard.

If the haze of the dielectric film is lower than 2%, the peel strength of the dielectric film with respect to the metal layer may deteriorate. On the other hand, if the haze of the dielectric film is higher than 25%, the luminous transmittance of the dielectric film may decrease, and thus, the efficiency of testing the circuit patterns 220 may decrease. Therefore, the surface of the dielectric film may be modified so that the dielectric film can have a haze of 2-25%.

The results of testing polyimide and a liquid crystal polymer for peel strength according to JIS C6471 Standard show that polyimide has a peel strength of 0.3-0.9 kN/m with respect to the metal layer and that a liquid crystal polymer has a peel strength of 1.1 kN/m with respect to the metal layer. Therefore, the dielectric film may be formed of a liquid crystal polymer.

The metal layer may be formed on the dielectric film by using sputtering, electroless plating or electroplating. The circuit patterns 320 are formed by etching the metal layer. The circuit patterns 320 include inner leads 320a, which are connected to the IC chip 330, and outer leads 320b, which are connected to a driving unit or a panel of a display device. The outer leads 320b may be connected to a driving unit or a panel of a display device by anisotropic conductive films (ACFs).

More specifically, the outer leads 320b may be connected to a driving unit or a panel of a display device through outer lead bonding (OLB) pads, and the inner leads 320a may be connected to the IC chip 330 through inner lead bonding (ILB) pads. The IC chip 330 and the inner leads 320a may be connected by plating the inner leads 320a with tin and applying heat or ultrasonic waves to the tin-plated inner leads 320a so as to generate a gold-tin bond between the tin-plated inner leads 320a and gold bumps on the IC chip 330.

The metal layer may have a double-layer structure including first and second metal layers. The first metal layer may be formed through sputtering or electroless plating and may include nickel chromium, gold or copper. The second metal layer may be formed through electroplating and may include gold or copper. In order to improve the efficiency of electroplating for forming the second metal layer, the first metal layer may be formed of a metal having a low resistance such as copper or nickel.

FIG. 3B illustrates a cross-sectional view taken along line 3-3' of FIG. 3A. Referring to FIG. 3B, the COF 300 includes the flexible film 310, which includes a dielectric film 312 and a metal layer 314 formed on the dielectric film 312, the IC chip 330, which is connected to the circuit patterns 320 on the metal layer 314, and gold bumps 340, which connect the IC chip 330 and the circuit patterns 320.

The dielectric film 312 is a base film of the flexible film 310 and may include a dielectric material such as polyimide, polyester, or a liquid crystal polymer. In order to improve the peel strength of the dielectric film 312 with respect to the metal layer 314, the surface of the dielectric film 312 may be modified using ion beams, plasma or alkali etching and may thus include defects. The surface of the dielectric film 312 may be modified so that the dielectric film 312 can have a haze of 2-25%.

The metal layer 314 is a thin layer formed of a conductive metal. The metal layer 314 may include a first metal layer, which is formed on the dielectric film 312, and a second metal layer, which is formed on the first metal layer. The first metal layer may be formed through sputtering or electroless plating and may include nickel, chromium, gold or copper. The second metal layer may be formed through electroplating and may include gold or copper.

The first metal layer may be formed of an alloy of nickel and chromium though sputtering. Alternatively, the first metal layer may be formed of copper through electroless plating. When using an alloy of nickel and chromium, the first metal layer may be formed to a thickness of about 30 nm. When using copper, the first metal layer may be formed to a thickness of 0.1 µm.

The first metal layer may be formed through electroless plating by immersing the dielectric film 312 in an electroless plating solution containing metal ions and adding a reducing agent to the electroless plating solution so as to extract the metal ions as a metal. The thickness of the first metal layer may be altered by adjusting the amount of time for which the dielectric film 312 is immersed in an electroless plating solution.

The second metal layer may be formed through electroplating, which involves applying a current to an electroplating solution and extracting metal ions contained in the electroplating solution as a metal. The thickness of the second metal layer may be determined according to the intensity of a current applied and the duration of the application of a current. The sum of the thicknesses of the first and second metal layers may be 4-13 µm.

The IC chip 330 is connected to the inner leads 320a of the circuit patterns 320 and transmits image signals provided by a driving unit of a display device to a panel of the display device. The pitch of the inner leads 320a may vary according to the resolution of a display device to which the COF 300 is connected. The inner leads 320a may have a pitch of about 30 µm. The IC chip 330 may be connected to the inner leads 320a through the gold bumps 340.

Referring to FIG. 3B, the COF 300, unlike the TCP 200, does not have any device hole 250. Therefore, the COF 300 does not require the use of flying leads and can thus achieve a fine pitch. In addition, the COF 300 is very flexible, and thus; there is no need to additionally form slits in the COF 300 in order to make the COF 300 flexible. Therefore, the efficiency of the manufacture of the COF 300 can be improved. For example, leads having a pitch of about 40 µm may be formed on the TCP 200, and leads having a pitch of about 30 µm can be formed on the COF 300. Thus, the COF 300 is suitable for use in a display device having a high resolution.

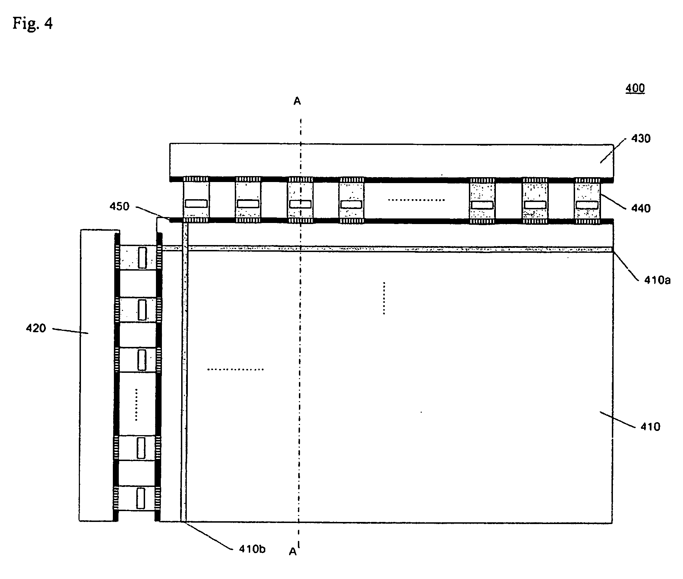

FIG. 4 illustrate diagram of a display device according to an embodiment of the present invention.

Referring to FIG. 4 the display device 400 according to an embodiment of the present invention may include a panel 410, which displays an image, a driving unit 420 and 430, which applies an image signal to the panel 410, a flexible film 440, which connects the panel 410 and the driving unit 420 and 430, and conductive films 450, which are used to attach the flexible film 440 to the panel 410 and to the driving unit 420 and 430. The display device 400 may be a flat panel display (FPD) such as a liquid crystal display (LCD), a plasma display panel (PDP) or an organic light-emitting device (OLED).

The panel 410 includes a plurality of pixels for displaying an image. A plurality of electrodes may be arranged on the panel 410 and may be connected to the driving unit 420 and 430. The pixels are disposed at the intersections among the electrodes. More specifically, the electrodes include a plurality of first electrodes 410a and a plurality of second electrodes 410b, which intersect the first electrodes 410a. The first electrodes 410a may be formed in row direction, and the second electrodes 410b may be formed in a column direction.

The driving units 420 and 430 may include a scan driver 420 and a data driver 430. The scan driver 420 may be connected to the first electrodes 410a, and the data driver 430 may be connected to the second electrodes 410b.

The scan driver 420 applies a scan signal to each of the first electrodes 410a and thus enables the data driver 430 to transmit a data signal to each of the second electrodes 410b. When the scan driver 420 applies a scan signal to each of the first electrodes 410a, a data signal can be applied to the first electrodes 410a, and an image can be displayed on the panel 400 according to a data signal transmitted by the data driver 430. Signals transmitted by the scan driver 420 and the data driver 430 may be applied to the panel 400 through the flexible films 440.

The flexible films 440 may have circuit patterns printed thereon. Each of the flexible films 440 may include a dielectric film, a metal layer, which is formed on the dielectric film, and an IC, which is connected to circuit patterns printed on the metal layer. Image signals applied by the driving units 420 and 430 may be transmitted to the first second electrodes 410a and the second electrodes 410b on the panel 410 through the circuit patterns and the IC of each of the flexible films 440. The flexible films 440 may be connected to the panel 410 and to the driving units 420 and 430 by the conductive films 450.

The conductive films 450 are adhesive thin films. The conductive films 450 may be disposed between the panel 410 and the flexible films 440, between the driving units 420 and 430 and the flexible films 440. The conductive films 450 may be anisotropic conductive films (ACFs).

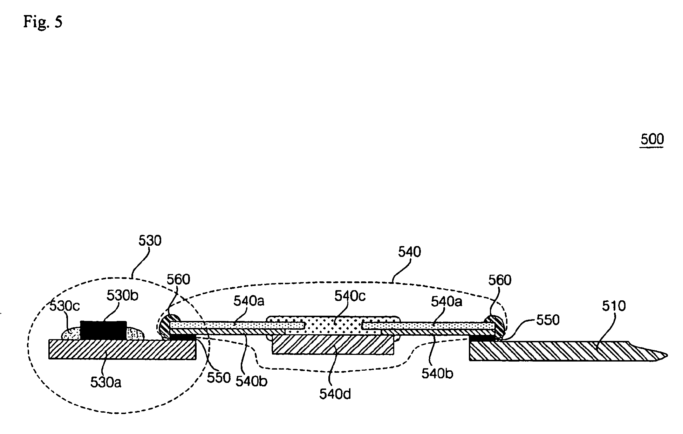

FIG. 5 is a cross-sectional view taken along line A-A' of the display device 400 in FIG. 4.

With reference to FIG. 5, the display device 500 comprises the panel 510 displaying an image, the data driver 530 that applies an image signal to the panel 510, the flexible film 540 connecting with the data driver 530 and the panel 510, and the conductive films 550 that electrically connects the flexible film 540 to the data driver 530 and the panel 510.

According to the embodiment of the present invention, the display device 500 may further comprise a resin 560 sealing up portions of the flexible film 540 contacting the conductive films 550. The resin 560 may comprise an insulating material and serve to prevent impurities that may be introduced into the portions where the flexible film 540 contacting the conductive films 550, to thus prevent damage of a signal line of the flexible film 540 connected with the panel 510 and the data driver 530, and lengthen a life span.

Although not shown, the panel 510 may comprise a plurality of scan electrodes disposed in the horizontal direction and a plurality of data electrodes disposed to cross the scan electrodes. The data electrodes disposed in the direction A-A' are connected with the flexible film 540 via the conductive film 550 as shown in FIG. 5 in order to receive an image signal applied from the data driver 530 and thus display a corresponding image.

The data driver 530 includes a driving IC 530b formed on a substrate 530a and a protection resin 530c for protecting the driving IC 530b. The protection resin 530c may be made of a material with insulating properties and protects a circuit pattern (not shown) formed on the substrate 530a and the driving IC 530b against impurities that may be introduced from the exterior. The driving IC 530b applies an image signal to the panel 510 via the flexible film 540 according to a control signal transmitted from a controller (not shown) of the display device 500.

The flexible film 540 disposed between the panel 510 and the data driver 530 includes polyimide film 540a, metal film 540b disposed on the polyimide films 540a, an IC 540c connected with a circuit pattern printed on the metal film 540b, and a resin protection layer 540d sealing up the circuit pattern and the IC 540c.

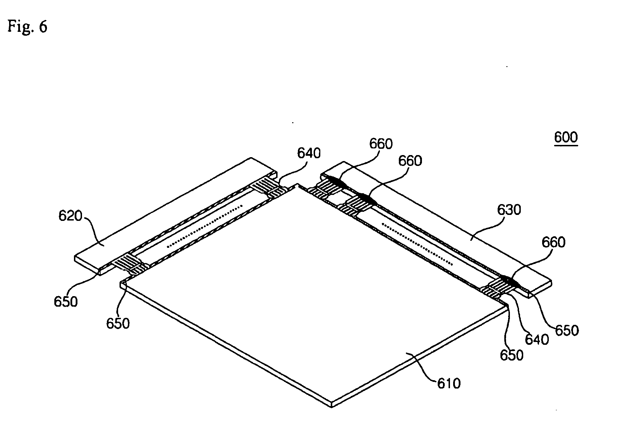

FIG. 6 illustrates diagram of a display device according to an embodiment of the present invention.
When the flexible films 640 are attached with the panel 610 and the driving units 620 and 630 through the conductive films 650, the flexible films 640 attached with the conductive films 650 can be sealed with the resin 660. With reference to FIG. 6, because the portions of the flexible films 640 attached to the conductive films 650 can be sealed with the resin 660, impurities that may be introduced from the exterior can be blocked.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A flexible film (100a, 100b, 100c) comprising:
a dielectric film (110a, 110b, 110c) comprising a modified surface (115a, 115b, 115c); and
a metal layer (120a, 120b, 120c) disposed on the modified surface (115a, 115b, 115c) of the dielectric film (110a, 110b, 110c),
wherein the haze of the dielectric film (110a, 110b, 110c) is 2 to 25%.

2. The flexible film of claim 1, wherein the dielectric film comprises at least one of polyimide, polyester and a liquid crystal polymer.

3. The flexible film of claim 1, wherein the metal layer comprises at least one of nickel, chromium, gold, and copper.

4. The flexible film (100c) of claim 1, wherein the metal layer (120c, 130c) comprises:
a first metal layer (120c) disposed on the dielectric film (110c); and
a second metal layer (130c) disposed on the first metal layer (120c).

5. The flexible film of claim 1, wherein the ratio of the thickness of the metal layer to the thickness of the dielectric film is 1:1.5 to 1:10.

6. A flexible film of claim 1, further comprising:
an integrated circuit (IC) chip disposed on the metal layer,
wherein the metal layer includes circuit patterns formed thereon; and
wherein the IC chip is connected to the circuit patterns.

7. The flexible film of claim 6, further comprising gold bumps through which the IC chip is connected to the circuit patterns.

8. A display device comprising:
a panel;
a driving unit; and
a flexible film according to claim 6 disposed between the panel and the driving unit.

9. The display device of claim 8, further comprising a conductive film connecting at least one of the panel and the driving unit to the flexible film.

10. The display device of claim 9, further comprising a resin sealing up a portion of the flexible film contacting the conductive film.

## Patentansprüche

1. Flexible Folie (100a, 100b, 100c) umfassend:
eine dielektrische Schicht (110a, 110b, 110c), die eine veränderte Oberfläche (115a, 115b, 115c) umfasst; und
eine Metallschicht (120a, 120b, 120c), die auf der veränderten Oberfläche (115a, 115b, 115c) der dielektrischen Schicht (110a, 110b, 110c) angeordnet ist,
wobei die Trübung der dielektrischen Schicht (110a, 110b, 110c) 2 bis 25% beträgt.

2. Flexible Folie nach Anspruch 1, wobei die dielektrische Schicht Polyimid, Polyester oder/und ein Flüssigkristallpolymer umfasst.

3. Flexible Folie nach Anspruch 1, wobei die Metallschicht Nickel, Chrom, Gold oder/und Kupfer umfasst.

4. Flexible Folie (100c) nach Anspruch 1, wobei die Metallschicht (120c, 130c) umfasst:
eine erste Metallschicht (120c), die auf der dielektrischen Schicht (110c) angeordnet ist; und
eine zweite Metallschicht (130c), die auf der ersten Metallschicht (120c) angeordnet ist.

5. Flexible Folie nach Anspruch 1, wobei das Verhältnis der Dicke der Metallschicht zu der Dicke der dielektrischen Schicht 1:1,5 bis 1:10 beträgt.

6. Flexible Folie nach Anspruch 1, weiter umfassend:
einen auf der Metallschicht angeordneten Chip mit einem integrierten Schaltkreis (IC),
wobei die Metallschicht darauf ausgebildete Schaltungsmuster umfasst; und
wobei der IC-Chip mit den Schaltungsmustern verbunden ist.

7. Flexible Folie nach Anspruch 6, weiter umfassend Goldkontakthügel, durch welche der IC-Chip mit den Schaltungsmustern verbunden ist.

8. Anzeigevorrichtung umfassend:
ein Panel;
eine Ansteuereinheit; und
eine flexible Folie nach Anspruch 6, die zwischen dem Panel und der Ansteuereinheit angeordnet ist.

9. Anzeigevorrichtung nach Anspruch 8, weiter umfassend eine leitende Schicht, welche das Panel oder/und die Ansteuereinheit mit der flexiblen Folie verbindet.

10. Anzeigevorrichtung nach Anspruch 9, weiter umfassend ein Harz, das einen die leitende Schicht kontaktierenden Teil der flexiblen Folie abdichtet.

## Revendications

1. Film flexible (100a, 100b, 100c) comprenant :
un film diélectrique (110a, 110b, 110c) comprenant une surface modifiée (115a, 115b, 115c) ; et
une couche métallique (120a, 120b, 120c) disposée sur la surface modifiée (115a, 115b, 115c) du film diélectrique (110a, 110b, 110c),
dans lequel le trouble du film diélectrique (110a, 110b, 110c) est 2 à 25 %.

2. Film flexible selon la revendication 1, dans lequel le film diélectrique comprend au moins un d'un polyimide, d'un polyester et d'un polymère à cristaux liquides.

3. Film flexible selon la revendication 1, dans lequel la couche métallique comprend au moins un du nickel, du chrome, de l'or et du cuivre.

4. Film flexible (100c) selon la revendication 1, dans lequel la couche métallique (120c, 130c) comprend :
une première couche métallique (120c) disposée sur le film diélectrique (110c); et
une deuxième couche métallique (130c) disposée sur la première couche métallique (120c).

5. Film flexible selon la revendication 1, dans lequel le rapport de l'épaisseur de la couche métallique sur l'épaisseur du film diélectrique est 1:1,5 à 1:10.

6. Film flexible selon la revendication 1, comprenant en outre :
une puce à circuit intégré (IC) disposée sur la couche métallique,
dans lequel la couche métallique inclut des motifs de circuit formés sur celle-ci ; et
dans lequel la puce IC est connectée aux motifs de circuit.

7. Film flexible selon la revendication 6, comprenant en outre des bosses d'or à travers lesquelles la puce IC est connectée aux motifs de circuit.

8. Dispositif d'affichage comprenant :
un panneau ;
une unité d'excitation ; et
un film flexible selon la revendication 6 disposé entre le panneau et l'unité d'excitation.

9. Dispositif d'affichage selon la revendication 8, comprenant en outre un film conducteur connectant au moins un du panneau et de l'unité d'excitation au film flexible.

10. Dispositif d'affichage selon la revendication 9, comprenant en outre une résine isolant une partie du film flexible au contact du film conducteur.
